# EUROPEAN PATENT APPLICATION

(11) **EP 2 835 230 A2**
(43) Date of publication of application: **11.02.2015**
(21) Application number: 14180251.2
(22) Date of filing: 07.08.2014
(51) Int. Cl.: B25J 9/16

(54) **Robot control apparatus and method for controlling robot**

(30) Priority: 09.08.2013 JP 2013165816
(71) Applicant: Kabushiki Kaisha Yaskawa Denki, Kitakyushu-shi, Fukuoka 806-0004 (JP)
(72) Inventor: Hashiguchi, Yukio, Kitakyushu-shi, Fukuoka 806-0004 (JP); Murai, Shinji, Kitakyushu-shi, Fukuoka 806-0004 (JP); Shiraki, Tomoyuki, Kitakyushu-shi, Fukuoka 806-0004 (JP)
(74) Representative: Viering, Jentschura & Partner Patent- und Rechtsanwälte

(57) **Abstract**

A robot control apparatus 1 includes a storage section 102, a display control section 19, and a work program preparation section 18. The storage section 102 associates information of work performed by a robot with a template to prepare a work program indicating content of the work, and stores the information in association with the template. The display control section 19 controls a display section 107 to display, in order, setting windows respectively corresponding to work steps of the work. In response to an operator selecting the work, the work program preparation section 18 prepares the work program indicating the content of the work selected by the operator based on the template corresponding to the work selected by the operator and based on setting information that the operator inputs on at least one setting window among the setting windows.

## Description

### BACKGROUND

### FIELD OF THE INVENTION

The present invention relates to a robot control apparatus and a method for controlling a robot.

### DISCUSSION OF THE BACK GROUND

Industrial articulated robots and other industrial robots are connected with robot control apparatuses each including a computer as a main unit. The robot control apparatus controls movement of the robot based on a movement control program. Specifically, upon execution of the movement control program, various control commands are transmitted to the robot, and in response to the control commands, the robot makes an expected movement.

The contents of Japanese Unexamined Patent Application Publication 5-119824 are incorporated herein by reference in their entirety.

In a production site in which a plurality of robots are installed, it is necessary to execute a movement control program suitable for each individual robot. This movement control program contains a work program indicating the content of work performed by the robot in association with movement paths including information of the position and posture of the installed robot. In order to control each individual robot to perform an expected kind of work, it is necessary to prepare a work program suitable for each individual robot. However, much of the work program is prepared manually by an operator, and this generally requires a skilled and experienced technique.

The present disclosure has been made in view of the above-described circumstances, and it is an object of the present disclosure to provide a robot control apparatus and a method for controlling a robot that facilitate preparation of a work program that indicates the content of work performed by the robot.

### SUMMARY

According to one aspect of the present disclosure, a robot control apparatus 1 includes a storage section 102, a display control section 19, and a work program preparation section 18. The storage section 102 is configured to associate information of work performed by a robot with a template to prepare a work program indicating content of the work, and configured to store the information in association with the template. The display control section 19 is configured to control a display section 107 to display, in order, setting windows respectively corresponding to work steps of the work. The work program preparation section 18 is configured to, in response to an operator selecting the work, prepare the work program indicating the content of the work selected by the operator based on the template corresponding to the work selected by the operator and based on setting information that the operator inputs on at least one setting window among the setting windows.

According to another aspect of the present disclosure, a method for controlling a robot includes, in response to an operator selecting work performed by a robot, acquiring from a storage section 102 a template corresponding to the work to prepare a work program indicating content of the work. The storage section 102 stores the template in association with information of the work. Setting windows respectively corresponding to work steps of the work are displayed in order. The work program indicating the content of the work is prepared based on the acquired template and based on setting information that the operator inputs on at least one setting window among the setting windows.

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings, wherein:
FIG. 1 is a block diagram illustrating a configuration of a robot control apparatus according to an embodiment;
FIG. 2 is a block diagram illustrating a task-planning configuration of the robot control apparatus;
FIG. 3 schematically illustrates an exemplary work table;
FIG. 4 schematically illustrates exemplary templates of sub-job programs;
FIG. 5 schematically illustrates an exemplary CAD data table;
FIG. 6 schematically illustrates an exemplary work parameter table;
FIG. 7 schematically illustrates an exemplary robot information table;
FIG. 8 schematically illustrates an exemplary setting window in task planning;
FIG. 9 is a block diagram illustrating a task-planning configuration of the robot control apparatus;
FIG. 10 illustrates an operation of the task planning of the robot control apparatus;
FIG. 11 illustrates an operation of the task planning of the robot control apparatus;
FIG. 12 schematically illustrates an exemplary initial setting window (setting window 0x);
FIG. 13 schematically illustrates an exemplary setting window 1x;
FIG. 14 schematically illustrates an exemplary setting window 2x;
FIG. 15 schematically illustrates an exemplary updated setting window 2x;
FIG. 16 schematically illustrates an exemplary setting window 3x;
FIG. 17 schematically illustrates an exemplary updated setting window 3x;
FIG. 18 schematically illustrates an exemplary setting window 4x;
FIG. 19 schematically illustrates an exemplary setting window 5x;
FIG. 20 schematically illustrates an exemplary setting window 5x in step 2;
FIG. 21 schematically illustrates an exemplary setting window 5x in step 3;
FIG. 22 schematically illustrates an exemplary work program;
FIG. 23 is a block diagram illustrating a path-planning configuration of the robot control apparatus;
FIG. 24 schematically illustrates an exemplary setting window in path planning;
FIG. 25 is a block diagram illustrating a path-planning configuration of the robot control apparatus;
FIG. 26 illustrates an operation of the path planning of the robot control apparatus;
FIG. 27 illustrates an operation of the path planning of the robot control apparatus;
FIG. 28 schematically illustrates an exemplary initial setting window (setting window 0y);
FIG. 29 schematically illustrates an exemplary setting window 1y;
FIG. 30 schematically illustrates an exemplary setting window 2y;
FIG. 31 schematically illustrates an exemplary setting window 3y;
FIG. 32 schematically illustrates an exemplary setting window 3y;
FIG. 33 schematically illustrates an exemplary setting window 3y;
FIG. 34 schematically illustrates an exemplary movement control program; and
FIG. 35 is a block diagram illustrating a general arrangement of a robot system.

### DESCRIPTION OF THE EMBODIMENTS

The embodiments will now be described in detail with reference to the accompanying drawings, wherein like reference numerals designate corresponding or identical elements throughout the various drawings.

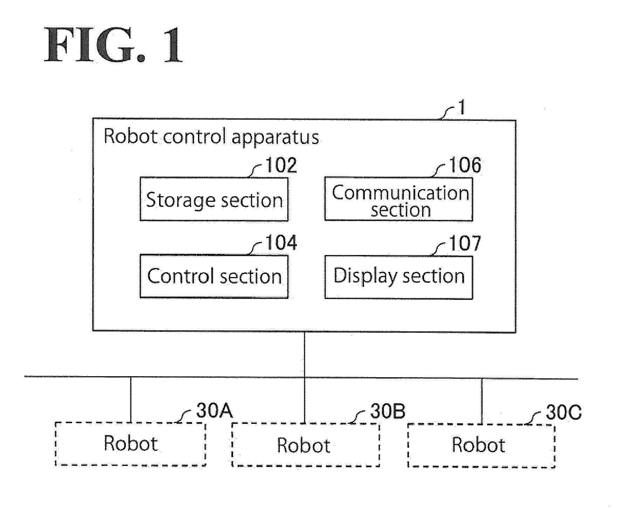

FIG. 1 is a block diagram illustrating a configuration of a robot control apparatus according to an embodiment. A robot control apparatus 1 supports and controls movement of a robot or a plurality of robots (for example, industrial articulated robots). The robot control apparatus 1 is communicable with the robots through a network. In FIG. 1, the single robot control apparatus 1 is coupled to three robots 30A, 30B, and 30C in a communicable manner through a network. It should be noted that four or more robots 30 may be coupled to the single robot control apparatus 1. It is also possible to provide a plurality of robot systems each provided with a single robot control apparatus 1 and a single robot 30 coupled to each other.

The robot control apparatus 1 according to this embodiment prepares a movement control program for controlling movement of the robot 30 prior to introduction of the robot 30 or prior to re-arrangement of the robot 30, that is, at an initial setting stage at which the robot control apparatus 1 and the robot 30 are in an off-line environment. In the movement control program, a work program indicating the content of work performed by the robot 30 is associated with movement path information including information of the position and posture of the installed robot 30. The robot 30 performs an expected kind of work based on the movement control program. In order to prepare the movement control program, the robot control apparatus 1 functions as a task planner and a path planner. The task planner performs task planning to prepare the work program for the work performed by the robot 30. The path planner performs path planning to prepare movement paths of the robot 30.

As shown in FIG. 1, the robot control apparatus 1 includes a storage section 102, a control section 104, a communication section 106, and a display section 107. An example of the storage section 102 is a hard disc or a semiconductor memory. The control section 104 includes a CPU as a main unit. An example of the communication section 106 is a network adapter to communicate with the robots 30A, 30B, and 30C. The display section 107 displays various setting windows (operation windows) for an operator to perform task planning and path planning. The task planning and the path planning are performed at the initial setting stage, which is before coupling of the robots 30A, 30B, and 30C to the robot control apparatus 1. For this reason, FIG. 1 imaginarily shows the robots 30A, 30B, and 30C, which are to be coupled to the robot control apparatus 1, for convenience of description. The following description will be regarding a task-planning configuration and a path-planning configuration of the robot control apparatus 1. Also the following description will mainly exemplify the single robot control apparatus 1 and the single robot 30A to be coupled to the robot control apparatus 1.

### [Task planning]

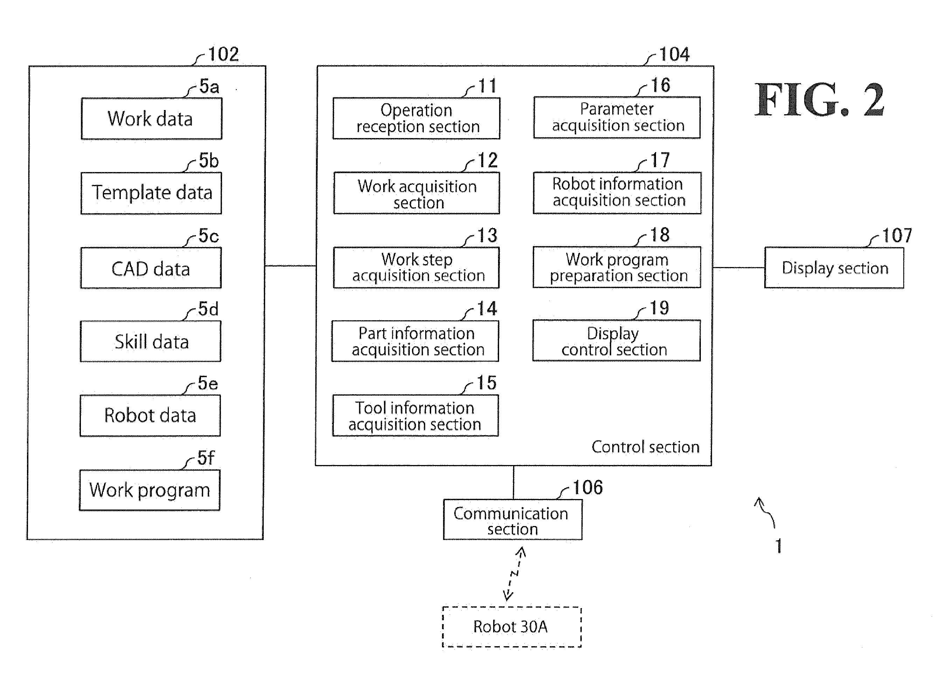

FIG. 2 is a block diagram illustrating a configuration of the robot control apparatus 1 including elements to perform the task planning. As shown in FIG. 2, the control section 104 includes an operation reception section 11, a work acquisition section 12, a work step acquisition section 13, a part information acquisition section 14, a tool information acquisition section 15, a parameter acquisition section 16, a robot information acquisition section 17, a work program preparation section 18, and a display control section 19. These sections are functions implemented upon execution of programs in the control section 104, which includes the CPU as a main unit. The storage section 102 includes storage areas, namely, a work data area 5a, a template data area 5b, a CAD data area 5c, a skill data area 5d, a robot data area 5e, and a work program area 5f.

The functions of the elements of the robot control apparatus 1 will be described.

The display control section 19 controls the display section 107 to display various setting windows to receive instructions (operations) from the operator. The operation reception section 11 receives the instructions from the operator. On the setting windows for the task planning, the operator gives an instruction using, for example, an operation device (not shown) coupled to the robot control apparatus 1, examples including, but not limited to, a keyboard and a mouse.

Based on the content of the instruction from the operator, the robot control apparatus 1 prepares a work program indicating the content of the work performed by the robot 30A. Here, the work (job) includes a plurality of work steps (sub-jobs). An example of the work (job) is "assembly of motor casing parts", which includes three work steps (sub-jobs), namely, pressing (step 1: sub-job 1), picking (step 2: sub-job 2), and insertion (step 3: sub-job 3). The robot 30A makes a movement based on a work program that corresponds to the work including this series of work steps.

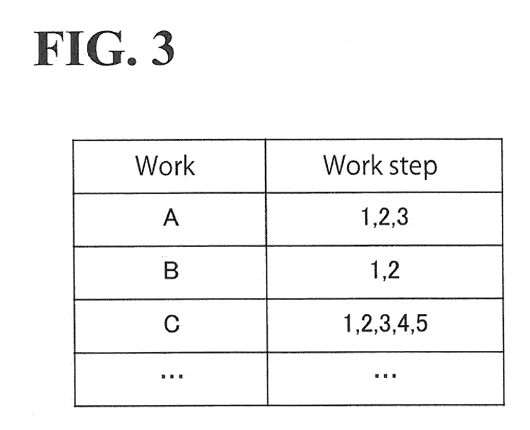

When the operator selects a desired type of work, the work acquisition section 12 acquires a result of the selection. A selection of types of work is registered in the work data area 5a in advance. From among a plurality of types of work on a setting window (setting window 0x), the operator selects a type of work for which a work program is to be prepared. As shown in FIG. 3, the work data area 5a stores a work table. In the work table, exemplary work names such as work A, work B, and work C are on record in association with work steps included in each type of work. For example, work A is associated with three work steps (sub-jobs), namely, step 1 (sub-job 1), step 2 (sub-job 2), and step 3 (sub-job 3). The work acquisition section 12 also acquires information of the work steps associated with the work that has been selected by the operator.

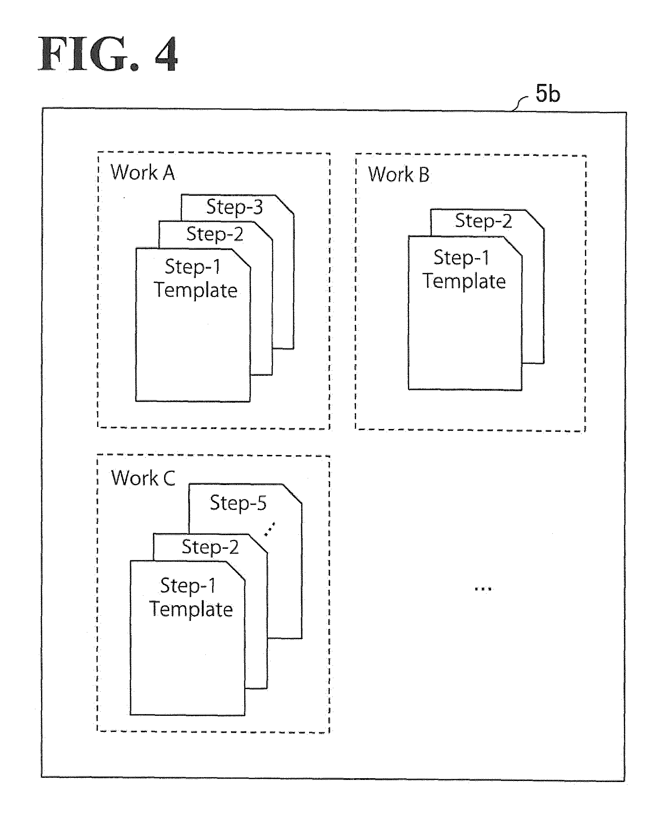

The operator selects a desired work step on a setting window (setting window 1f) from among the work steps of the work selected by the operator. The work step acquisition section 13 acquires a result of the selection, and also acquires from the template data area 5b a template of a sub-job program (work step program) corresponding to the selected work step. The template stores, for example, a style and formulaic phrases of the program. The template data area 5b stores templates of sub-job programs corresponding to the work steps of the work. In the case of a plurality of work steps, a template of a sub-job program is associated with each individual work step. In the example shown in FIG. 4, the template data area 5b stores templates of the programs of three work steps (sub-jobs), namely, step 1 (sub-job 1), step 2 (sub-job 2), and step 3 (sub-job 3) in association with work A.

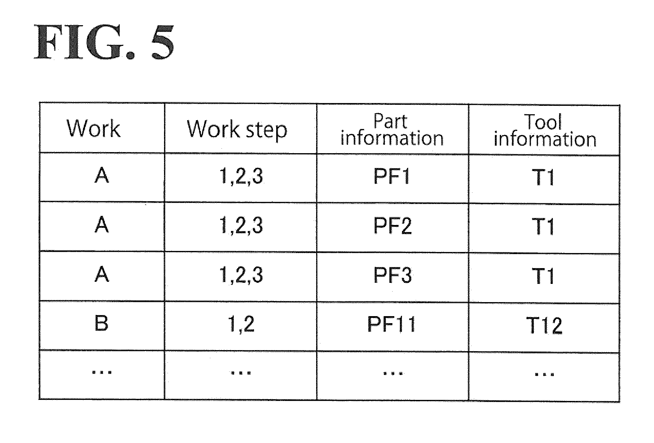

From the CAD data area 5c, the part information acquisition section 14 acquires information of a part (work target) corresponding to the work selected by the operator and information of a part that the operator has selected on a setting window (setting window 2x). As shown in FIG. 5, the CAD data area 5c stores a CAD data table. The CAD data table records work name, work steps, and part information in association with each other. The part information includes part name, identification information of the part (part ID), and three-dimensional model data of the part. The part information acquisition section 14 also acquires, from the CAD data area 5c, information of a work stand that the operator has selected on the setting window (setting window 2x). The information of each of the parts is associated with a coordinate system (part coordinate system), and the information of each of the work stands is associated with a coordinate system (work coordinate system).

From the CAD data area 5c, the tool information acquisition section 15 acquires information of a tool corresponding to the work selected by the operator, and information of a tool that the operator has selected on the setting window (setting window 2x). As shown in FIG. 5, the CAD data table of the CAD data area 5c additionally records tool information in association work name, work steps, and part information. The tool information association with work name, work steps, and part information. The tool information includes tool name, identification information of the tool (tool ID), and three-dimensional model data of the tool. The information of each of the tools is associated with a coordinate system (tool coordinate system).

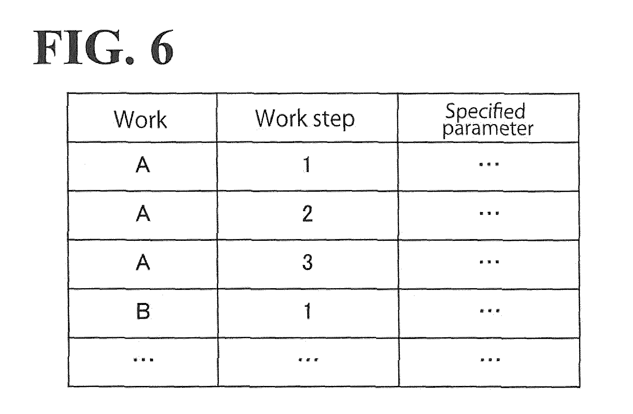

The parameter acquisition section 16 acquires a parameter (work condition) set on a setting window (setting window 3x) by the operator. Also the parameter acquisition section 16 refers to the skill data area 5d to determine whether the work parameter set by the operator satisfies a value (specified parameter (threshold) set in advance) suitable for the work step. That is, the parameter acquisition section 16 also functions as a determination section. As shown in FIG. 6, the skill data area 5d stores a work parameter table. The work parameter table records work name, work steps, and specified parameter in association with each other. Examples of the work parameter include, but are not limited to, part-to-part distance, position, pressing force, and gripping force.

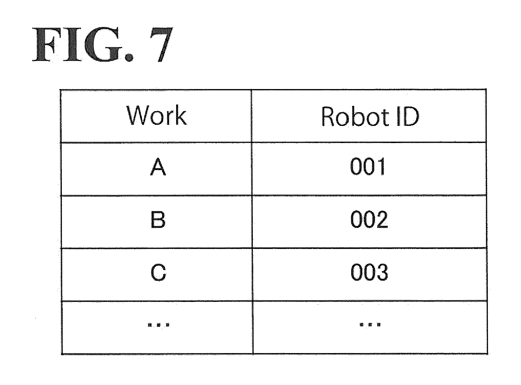

From the robot data area 5e, the robot information acquisition section 17 acquires information of a robot that the operator has selected on a setting window (setting window 4x). As shown in FIG. 7, the robot data area 5e stores a robot information table. The robot information table records work name and robot information in association with each other. The robot information includes robot name, identification information of the robot (robot ID), and three-dimensional model data indicating external shape of the robot. The information of each of the robots is associated with a coordinate system (robot coordinate system).

The work program preparation section 18 combines the template of the sub-job program acquired by the work step acquisition section 13 with the part information acquired by the part information acquisition section 14, the tool information acquired by the tool information acquisition section 15, the work parameter acquired by the parameter acquisition section 16, and the robot information acquired by the robot information acquisition section 17. Thus, a sub-job program is prepared. Further, based on the prepared sub-job program, the work program preparation section 18 prepares a work program corresponding to the work. The work program preparation section 18 associates the prepared work program with the sub-job program and stores the resulting work program in the work program area 5f

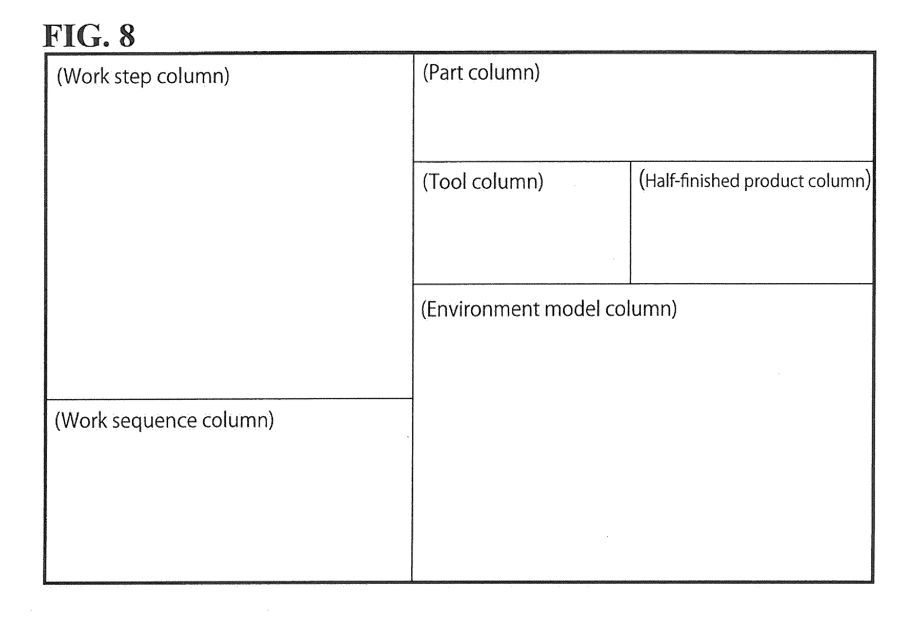

In the robot control apparatus 1, the display control section 19 controls the display section 107 to display the setting windows (including the setting windows 0x to 4x) that correspond to the processing of the above-described elements. Specific examples of the setting windows will be described later. As shown in FIG. 8, an exemplary setting window in the task planning contains a part column, a tool column, a half-finished product column, an environment model column, a work step column, and a work sequence column.

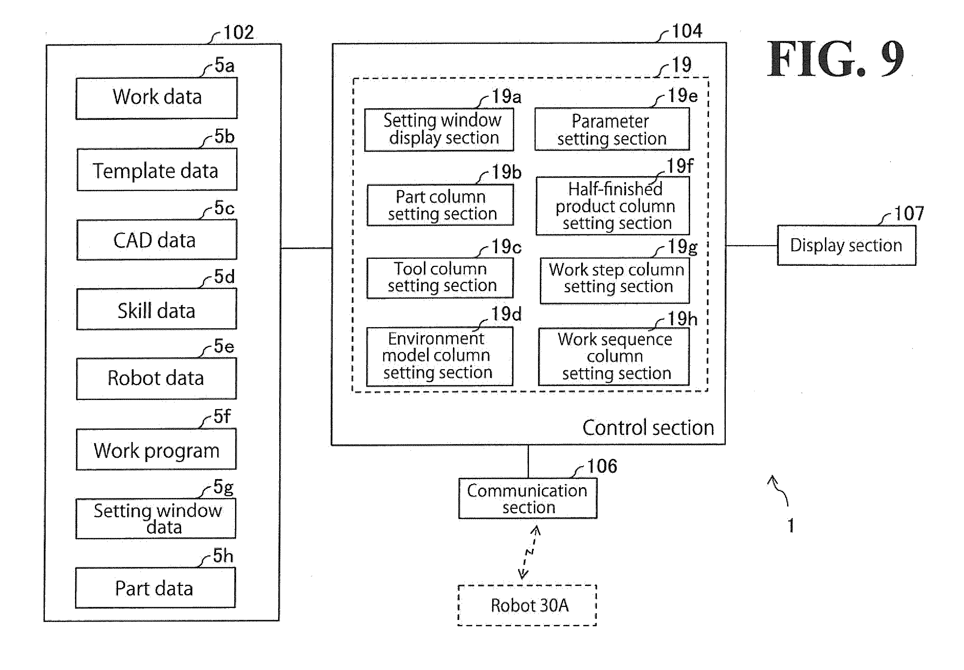

As shown in FIG. 9, the display control section 19 includes elements to display the setting windows, namely, a setting window display section 19a, a part column setting section 19b, a tool column setting section 19c, an environment model column setting section 19d, a parameter setting section 19e, a half-finished product column setting section 19f, a work step column setting section 19g, and a work sequence column setting section 19h. The storage section 102 includes additional storage areas, namely, a setting window data area 5g and a part data area 5h. In FIG. 9, the elements included in the control section 104 shown in FIG. 2 are omitted.

When the work acquisition section 12 acquires the work selected by the operator, the setting window display section 19a acquires from the setting window data area 5g a setting window corresponding to the work selected by the operator; the part column setting section 19b acquires from the CAD data area 5c (see FIG. 5) the three-dimensional model data of the part acquired by the part information acquisition section 14, and sets (registers) the three-dimensional model data of the part in the part column of the setting window; the tool column setting section 19c acquires from the CAD data area 5c the three-dimensional model data of the tool acquired by the tool information acquisition section 15, and sets (registers) the three-dimensional model data of the tool in the tool column of the setting window; and the environment model column setting section 19d acquires, from the CAD data area 5c, three-dimensional model data of a product to be made from the part acquired by the part information acquisition section 14 and to be made by the work acquired by the work acquisition section 12, and sets (registers) the three-dimensional model data of the product in the environment model column of the setting window. The three-dimensional model data set in each of the columns is displayed in the form of an image on the setting window. The part column setting section 19b stores, in the part data area 5h, three-dimensional model data of each of the parts set in the part column.

The half-finished product column setting section 19f refers to the part data area 5h to acquire three-dimensional model data (of a half-finished product, which is in the middle of production) at the time of execution of each work step. The half-finished product column setting section 19f sets (registers) the three-dimensional model data in the half-finished product column of the setting window. In the half-finished product column of the setting window, an image of the half-finished product is displayed.

In the work step column of the setting window, the work step column setting section 19g sets (registers) a selected object (three-dimensional model data of the part, the tool, or another element) that the operator has selected on the setting window. Examples of the method of setting the selected object in the work step column are that the operator uses a mouse pointer to drag the part image set (displayed) in the part column and drop the part image in the work step column, and that a list of a plurality of part names are displayed in the work step column, and the operator clicks on a desired part name using a mouse pointer.
The work step column of the setting window displays an image of the part, the tool, or another element that has been set.

In the work sequence column, the work sequence column setting section 19h sets (registers) a step name corresponding to each work step. Each step name is associated with a sub-job program, so that selecting (clicking on) the step name causes the content of the corresponding sub-job program to be displayed on the setting window.

The method of preparing the work program (task planning) in the robot control apparatus 1 will be described by referring to a specific example. This example is regarding a method of preparing a work program corresponding to the work "assembly of motor casing parts" (hereinafter referred to as work A). Work A includes three work steps, namely, pressing (step 1), picking (step 2), and insertion (step 3).

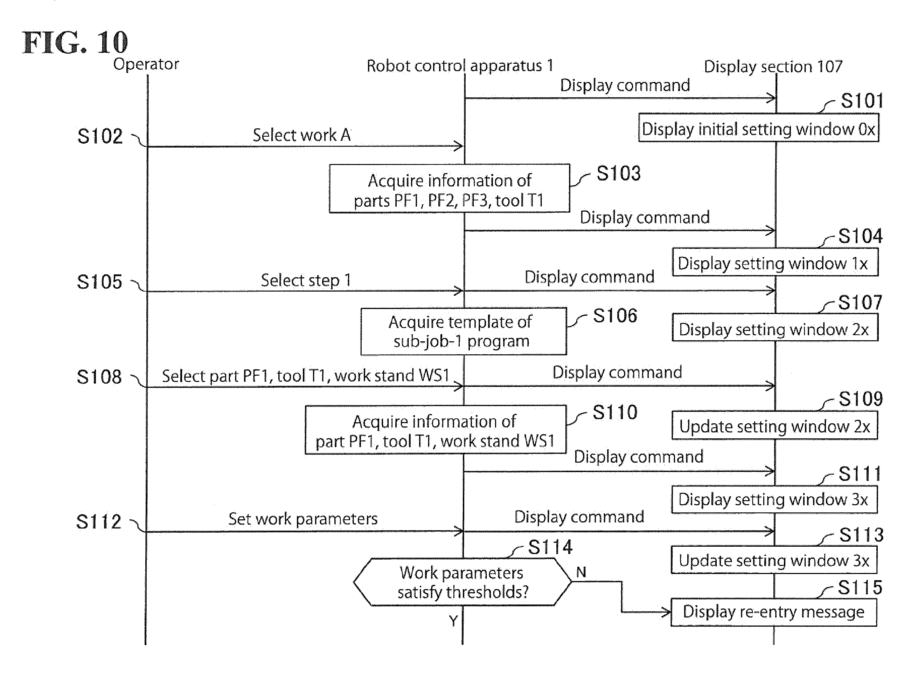

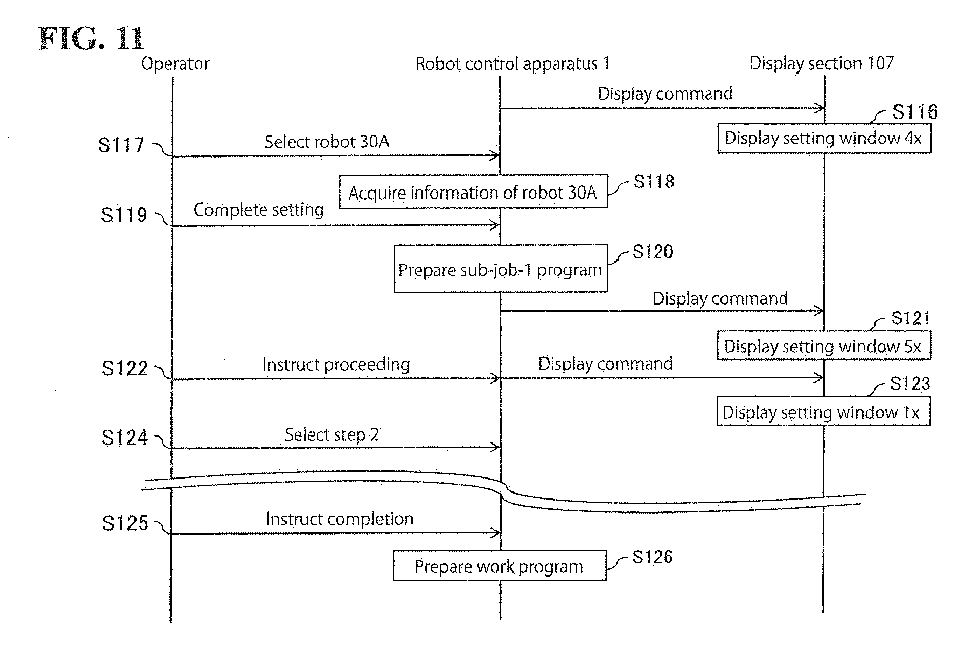

FIGs. 10 and 11 are flowcharts illustrating operations of the robot control apparatus 1. FIGs. 10 and 11 show a parallel arrangement of an operation flow of the operator, an operation flow of the robot control apparatus 1 based on the operation of the operator, and a display flow of the display section 107. The display processing of the display section 107 is implemented in accordance with a display command from the display control section 19 in the robot control apparatus 1.

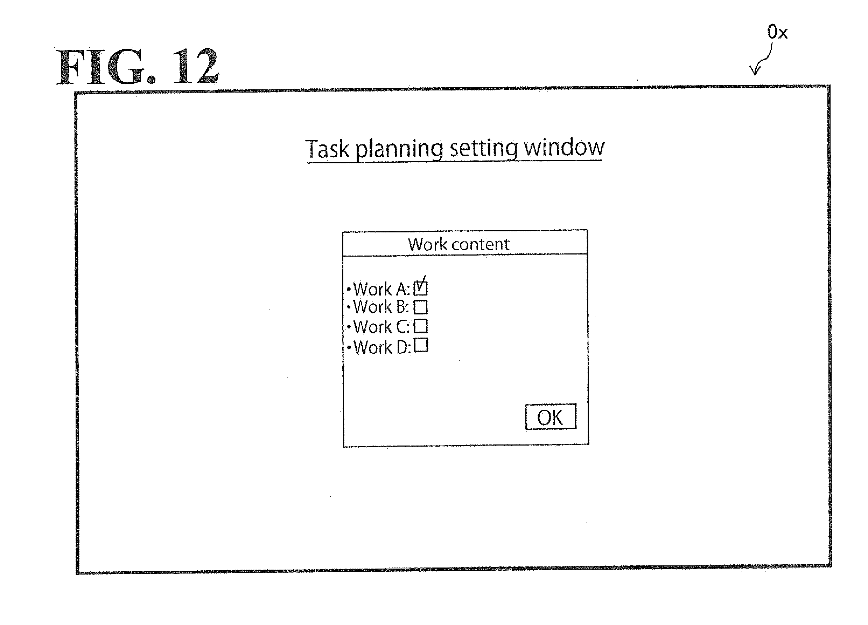

First, at the start of processing of the task planning, the display section 107 displays an initial setting window (S101). In the example shown in FIG. 12, the initial setting window displays a window (setting window 0x) for the operator to select work. On the initial setting window shown in FIG. 12, the operator selects "Work A" as the work and presses "OK" button (S102). When the work acquisition section 12 acquires a result of the selection (work A) by the operator, the part information acquisition section 14 acquires, from the CAD data area 5c, three-dimensional model data of parts PF1, PF2, and PF3, which correspond to work A (see FIG. 5). The tool information acquisition section 15 acquires, from the CAD data area 5c, three-dimensional model data of tool T1, which corresponds to work A (S103).

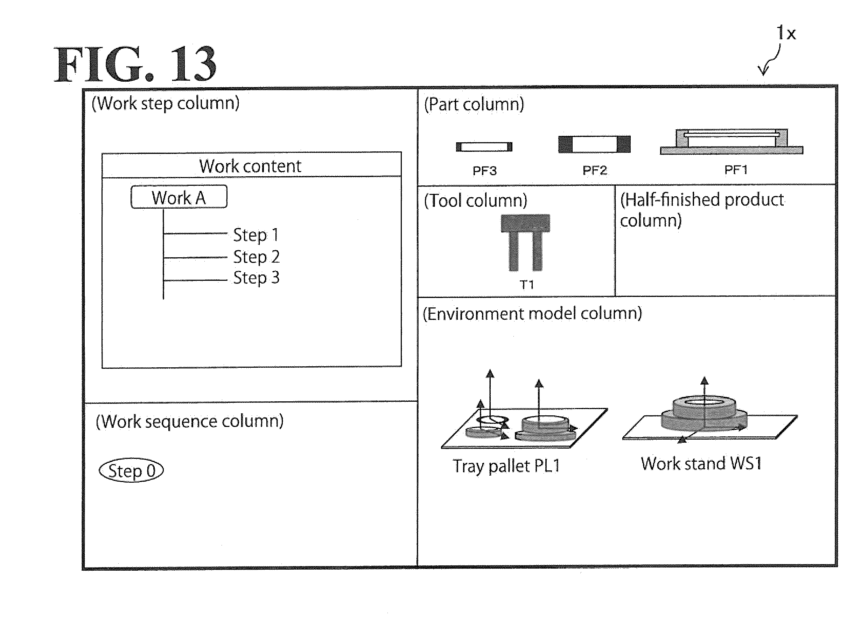

Next, the setting window display section 19a acquires a setting window corresponding to work A (see FIG. 8) from the setting window data area 5g. The part column setting section 19b sets the acquired three-dimensional model data of the parts PF1, PF2, and PF3 in the part column of the setting window. The tool column setting section 19c sets the acquired three-dimensional model data of tool T1 in the tool column of the setting window. The environment model column setting section 19d sets three-dimensional model data of the parts PF1, PF2, and PF3, a stand WS1, and a finished product in the environment model column of the setting window. The work step column setting section 19g sets the information of steps 1 to 3 included in work A in the work step column of the setting window. The work sequence column setting section 19h sets step 0 in the work sequence column of the setting window. Thus, the display section 107 displays setting window 1x, in which the display columns are filled in by the setting sections (S104). FIG. 13 shows an exemplary setting window 1x.

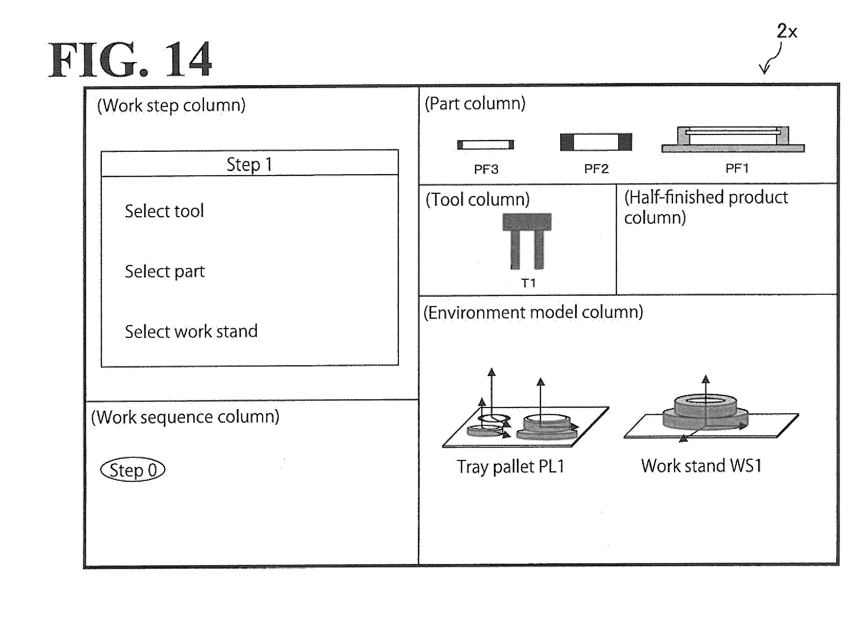

Next, on the setting window 1x, the operator selects "Step 1" included in work A (S105). For example, the operator uses a mouse to click on "Step 1" on the setting window. When the operator selects "Step 1", the work step acquisition section 13 acquires from the template data area 5b (see FIG. 4) a template of the sub-job-1 program, which corresponds to "Step 1" (S106). In the work step column, the work step column setting section 19g displays a setting column in which to set the parts, the tool, and the work stand (S107). FIG. 14 shows an exemplary setting window 2x including the setting column.

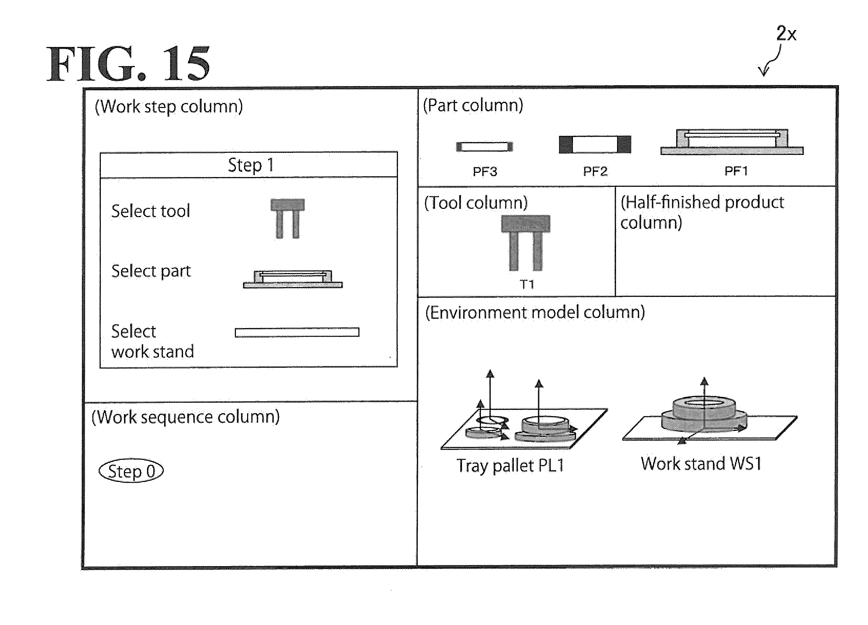

Next, on the setting window 2x, the operator selects part PF1, tool T1, and work stand WS1 (S108). For example, the operator uses a mouse to drag part PF1 set in the part column of the setting window 2x and drop part PF1 in the work step column; drag tool T1 set in the tool column and drop tool T1 in the work step column; and drag work stand WS1 set in the environment model column and drop work stand WS1 in the work step column. Thus, the work step column setting section 19g sets part PF1, work stand WS1, and tool T1 in the work step column, thereby updating the setting window 2x as shown in FIG. 15 (S109). From the CAD data area 5c, the part information acquisition section 14 acquires the information of part PF1 and work stand WS1, which have been selected by the operator. From the CAD data area 5c, the tool information acquisition section 15 acquires the information of tool T1, which has been selected by the operator (S110). The information of each of part PF1, work stand WS1, and tool T1 is associated with a coordinate system.

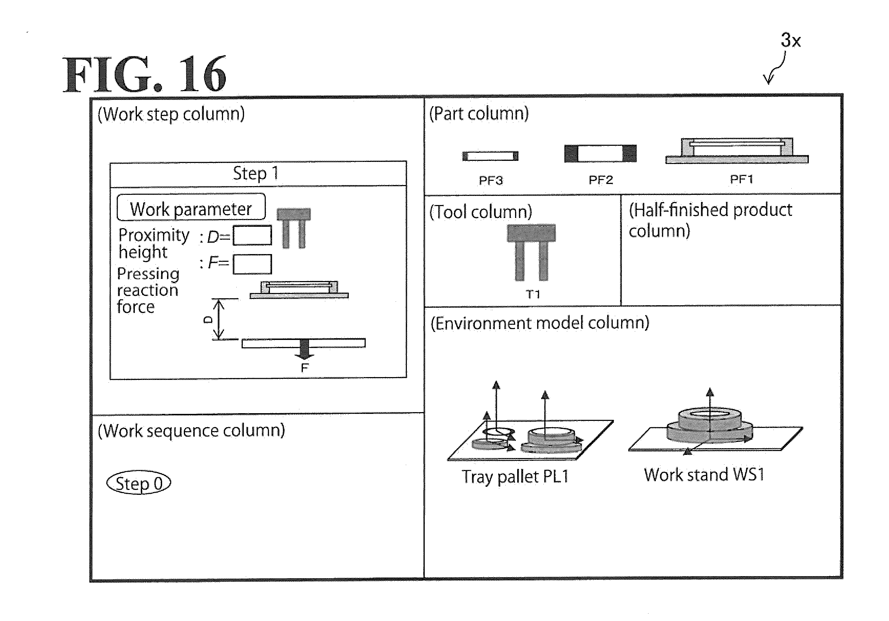

Next, the work step column setting section 19g displays in the work step column a setting column on which to set work parameters (S111). FIG. 16 shows an exemplary setting window 3x including the setting window.

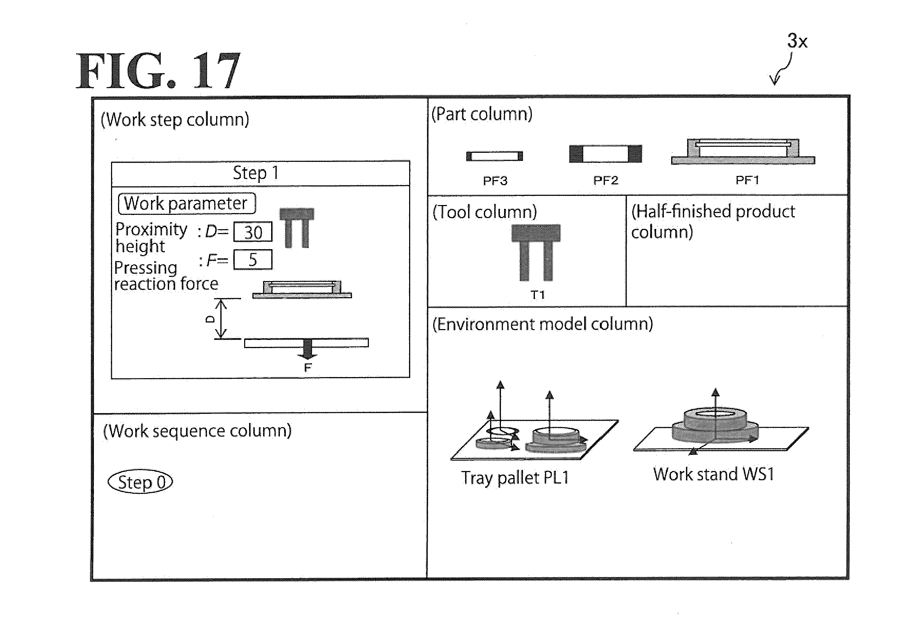

Next, the operator sets (inputs) work parameters on the setting window 3x (S112). For example, the operator sets a distance (proximity height) of D (mm) = 30 between work stand WS1 and part PF1, and a pressing reaction force of *F* (N) = 5. Thus, the setting window 3x is updated as shown in FIG. 17 (S113).

When the operator sets the work parameters, the parameter acquisition section 16 determines whether the work parameters satisfy specified parameters (thresholds) set in advance (S114).. When the work parameters do not satisfy the thresholds, the display control section 19 controls the display section 107 to display a message to prompt re-entry of work parameters (S 115).

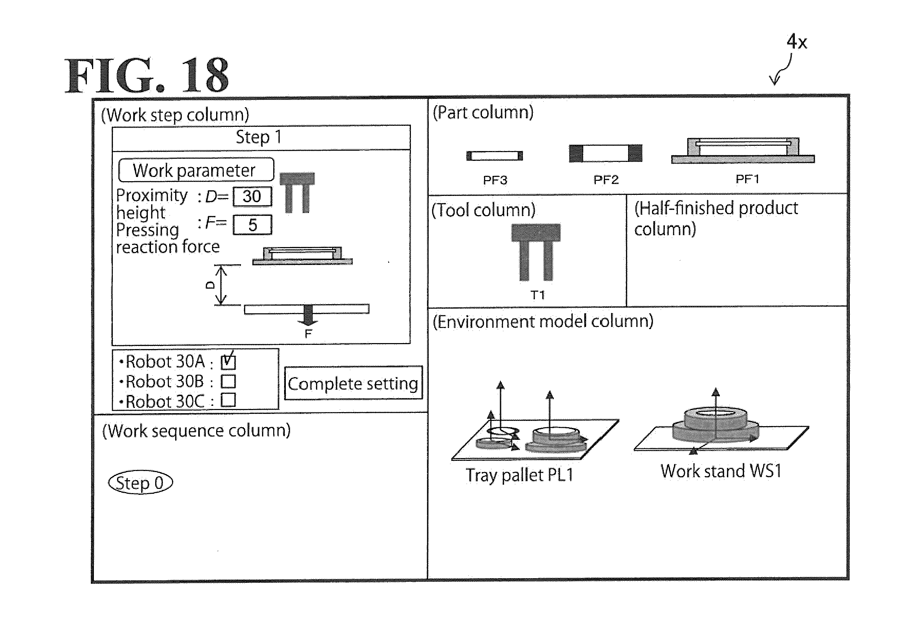

When the work parameters satisfy the thresholds, the work step column setting section 19g displays in the work step column a setting column on which to select a robot (S116). FIG. 18 shows an exemplary setting window 4x including the setting column.

Next, the operator selects the robot 30A on the setting window 4x (S117). From the robot data area 5e (see FIG. 7), the robot information acquisition section 17 acquires the information of the robot 30A, which has been selected by the operator (S118). The information of the robot 30A is associated with a robot coordinate system.

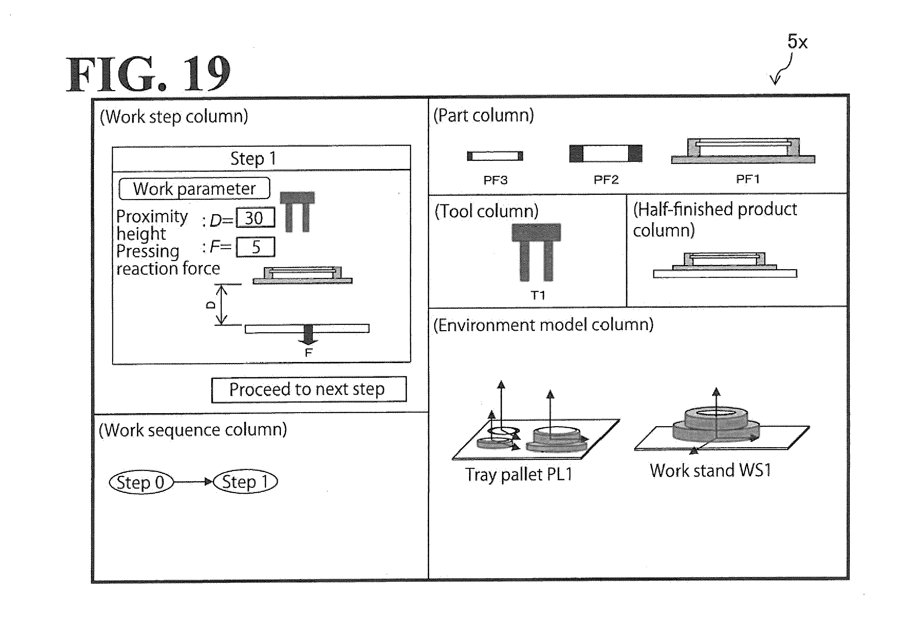

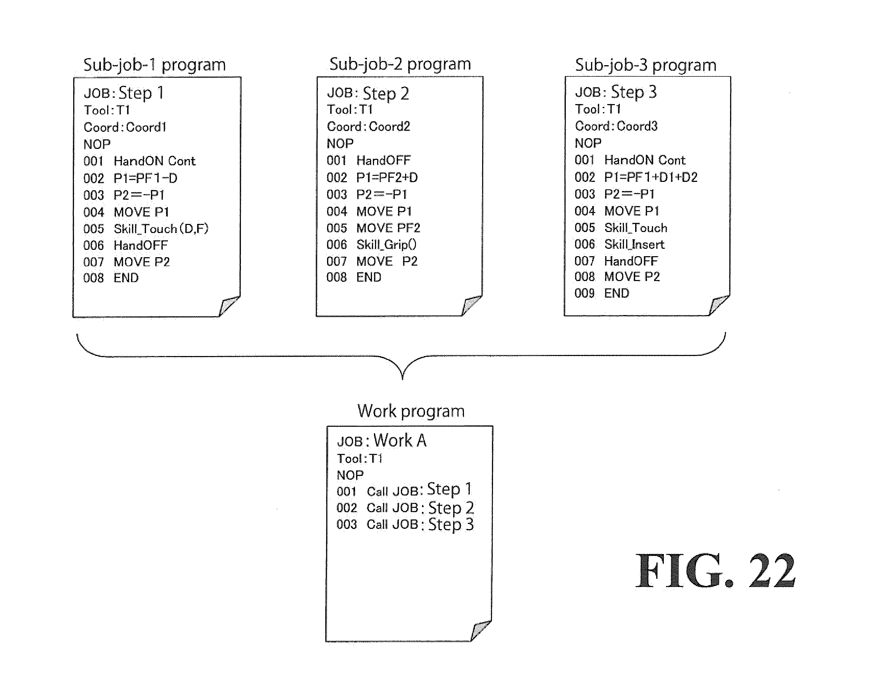

Next, when the operator presses "Complete setting" button included in the setting window 4x (S119), the work program preparation section 18 combines the template of the sub-job-1 program with the information of part PF1, tool T1, work stand WS1, the work parameters (*D* = 30, *F* = 5), and the robot 30A. Thus, the sub-job-1 program (see FIG. 22) is prepared (S120). In the half-finished product column of the setting window, the half-finished product column setting section 19f sets a state of pressing part PF1 against work stand WS1 (half-finished product: finished product of step 1). In the work sequence column, the work sequence column setting section 19h sets "Step 1", which is associated with the sub-Job-1 program (S121). FIG. 19 shows an exemplary setting window 5x set in this manner. Clicking on "Step 1" in the work sequence column causes the content of the sub-job-1 program (see FIG. 22) to be displayed.

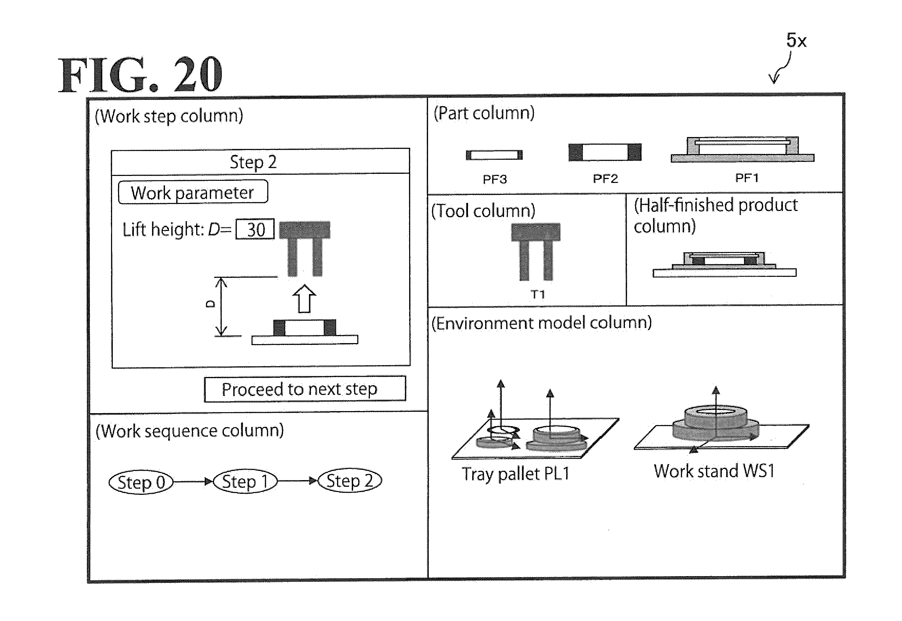

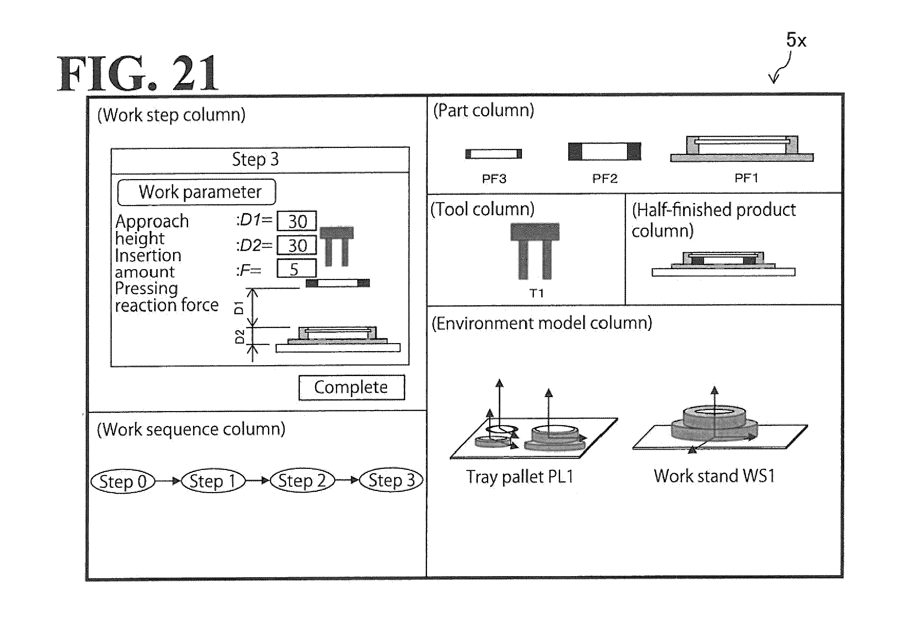

Next, when the operator gives an instruction to continue the task planning (for example, when the operator clicks on "Proceed to next process" on the setting window 5x) (S122), then the display section 107 again displays the setting window 1x with the columns filled in by the setting sections (S123). On the setting window 1x, the operator selects "Step 2" included in work A (see FIG. 13) (S124). Next, processing similar to processing of S106 to S120 described above is performed to prepare a sub-job-2 program (see FIG. 22), which corresponds to "Step 2". FIG. 20 shows an exemplary setting window 5x in step 2. Then, processing similar to processing of steps S106 to S120 is performed with regard to "Step 3" included in the work A to prepare a sub-job-3 program (see FIG. 22), which corresponds to "Step 3". FIG. 21 shows an exemplary setting window 5x in step 3.

Finally, when the operator gives an instruction to complete the task planning (for example, when the operator clicks on "Complete" on the setting window 5x) (S125), then the work program preparation section 18 prepares a work program corresponding to work A based on the sub-job-1 program, the sub-job-2 program, and the sub-job-3 program, which respectively correspond to steps 1 to 3 included in work A (S126). FIG. 22 shows examples of the sub-job-1 program, the sub-job-2 program, the sub-job-3 program, and the work program that corresponds to work A and is prepared based on these sub-job programs. The work program preparation section 18 associates the work program corresponding to work A with the sub-job-1 program, the sub-job-2 program, and the sub-job-3 program, and stores the resulting work program in the work program area 5f.

The task planning of the robot control apparatus 1 according to this embodiment facilitates preparation of the work program that indicates the content of the work performed by the robot. Also, the task planning of the robot control apparatus 1 enables the operator to recognize (visually confirm) the progress (development) of preparation of the work program. The work program prepared in the task planning indicates the content of the work without including position information of the robot and the work stand. This ensures continued utilization of the work program even if the type or the position of the robot is changed, for example.

### [Path planning]

Subsequently after the processing of the task planning has been ended, the operator makes the robot control apparatus 1 perform processing of path planning to preparing trajectories (movement paths) including information of the position and posture of the installed robot 30A. The processing of the path planning will be described below. For convenience of description, the elements that have approximately the same functions as the elements to perform the task planning are denoted with the same reference numerals, and descriptions of those elements will be omitted.

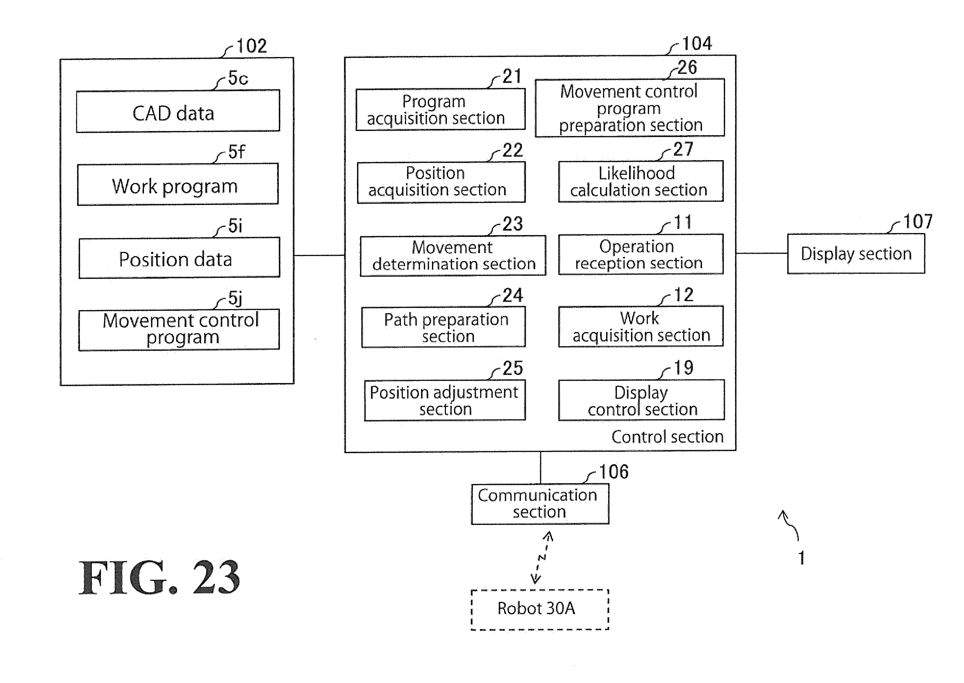

As shown in FIG. 23, the control section 104 includes elements to perform the path planning, namely, a program acquisition section 21, a position acquisition section 22, a movement determination section 23, a path preparation section 24, a position adjustment section 25, a movement control program preparation section 26, and a likelihood calculation section 27. These sections are functions implemented upon execution of programs in the control section 104, which includes the CPU as a main unit. The storage section 102 includes storage areas, namely, a position data area 5i and a movement control program area 5j.

Similarly to the task planning, the display control section 19 controls the display section 107 to display various setting windows to receive instructions from the operator, and the operation reception section 11 receives the instructions from the operator. On the setting windows for the path planning, the operator gives the instructions using an operation device coupled to the robot control apparatus 1, examples including, but not limited to, a keyboard and a mouse.

Based on the content of the instruction from the operator, the robot control apparatus 1 prepares movement paths for the robots 30 to perform work in accordance with work programs. This will be exemplified below with work A, which is related to the robot 30A, and with step 1, step 2, and step 3 included in work A.

The functions of the elements of the robot control apparatus 1 will be described.

The work program area 5f stores the work program corresponding to work A in association with the sub-job-1 program, the sub-job-2 program, and the sub-job-3 program. Position information and coordinate information of the sub-job programs (see FIG. 22) associated with the work program prepared in the task planning are described as *Coord, P1,* and *P2,* for example. These descriptions are unsettled, and determined in the processing of the path planning. Here, "*Coord*" indicates coordinate information (x, y, z), for example.
A coordinate system file 1 of *Coord 1* is associated with the sub-job-1 program. A coordinate system file 2 of *Coord 2* is associated with the sub-job-2 program. A coordinate system file 3 of *Coord 3* is associated with the sub-job-3 program. These coordinate system files are stored in the work program area 5f.

The position data area 5i stores coordinate systems of the respective parts, tools, work stands, and robots. For example, the position data area 5i stores coordinate systems of respective parts PF1, PF2, and PF3, tool T1, work stand WS1, and robot 30A. Also the position data area 5i stores designed positions (position measurement data) of the respective parts, tools, and work stands relative to the positions of the installed robots. This ensures that positional relationships (coordinate positions) of the parts PF1, PF2, and PF3, tool T1, work stand WS1, and the robot 30A, for example, are specified. It should be noted that the robots 30A, 30B, and 30C are manually installed at desired robot installation positions, and thus actual positions of the work stands relative to the robots 30A, 30B, and 30C may differ from the designed positions of the work stands. The designed relative positions of the parts, the tool, and the work stands are stored in association with the robot installation positions. Thus, the position data area 5i stores the coordinate position of each robot in association with the robot identification information.

The movement control program area 5j stores a movement control program. In the movement control program, the work program prepared in the task planning is associated with the movement path prepared in the path planning.

From the work program area 5f, the program acquisition section 21 acquires a work program targeted for the processing of the path planning. In this example, the program acquisition section 21 acquires the work program corresponding to work A. In this work program, the sub-job-1 program, the sub-job-2 program, and the sub-job-3 program are respectively associated with the coordinate system files 1, 2, and 3. The program acquisition section 21 acquires the work program when, for example, the operator gives an instruction to start the path planning.

From the position data area 5i, the position acquisition section 22 acquires the positions (coordinate systems) of the respective parts, tool, work stand, and robot. In this example, the position acquisition section 22 acquires the positions (coordinate systems) of respective parts PF1, PF2, and PF3, tool T1, work stand WS1, and robot 30A.

Based on the position information acquired by the position acquisition section 22, the movement determination section 23 determines whether the start point and the destination point of the movement in each step are within a movable range (within a predetermined range). The movable range is calculated based on the position information acquired by the position acquisition section 22. Also based on the position information acquired by the position acquisition section 22, the movement determination section 23 determines whether the robot 30A interferes with obstacles such as the other robots 30B and 30C and surrounding objects in the movement of each step. That is, the movement determination section 23 performs movement range checking and interference checking. When the movement range checking reveals that the start point and the destination point of the movement in each step are within the movable range, the movement determination section 23 determines this state as normal. When the interference checking reveals no interference between the robot and the obstacles, the movement determination section 23 determines this state as normal. The movement determination section 23 determines otherwise states as abnormal. It is possible to perform the movement range checking and the interference checking by simulating the movement of the robots 30 in their work space in virtual space using the three-dimensional model data stored in the CAD data area 5c.

Based on a result of the determination by the movement determination section 23, the path preparation section 24 prepares a movement path of the robot between two successive steps in the production order. For example, the path preparation section 24 prepares a movement path 0-1 of the robot 30A between step 0 and step 1, a movement path 1-2 of the robot 30A between step 1 and step 2, and a movement path 2-3 of the robot 30A between step 2 and step 3. Also the path preparation section 24 stores information of the prepared movement paths in the work program area 5f.

When the result of the determination by the movement determination section 23 is "abnormal", the position adjustment section 25 adjusts the positional relationship of the work stand and the robot in the virtual space.

The movement control program preparation section 26 associates the movement paths prepared by the path preparation section 24 with the work program prepared in the task planning so as to prepare a movement control program. The movement control program preparation section 26 stores the prepared movement control program in the movement control program area 5j.

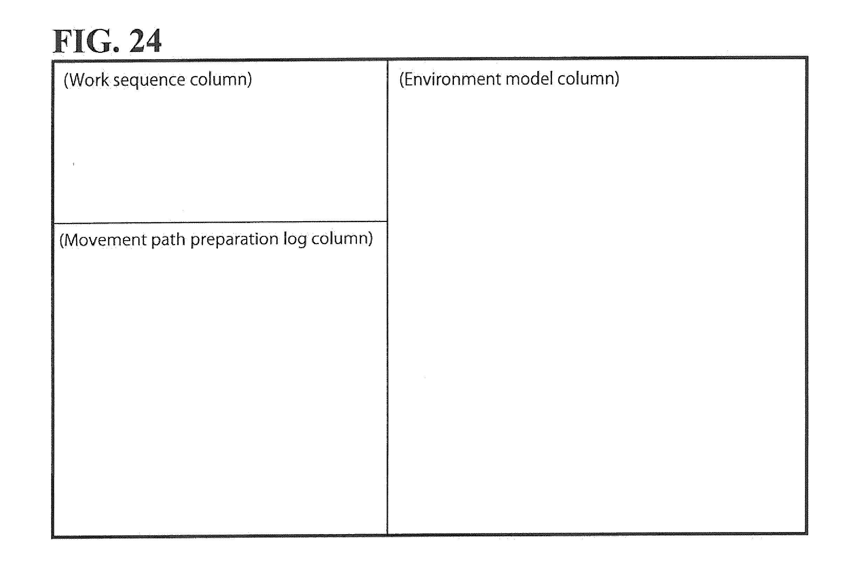

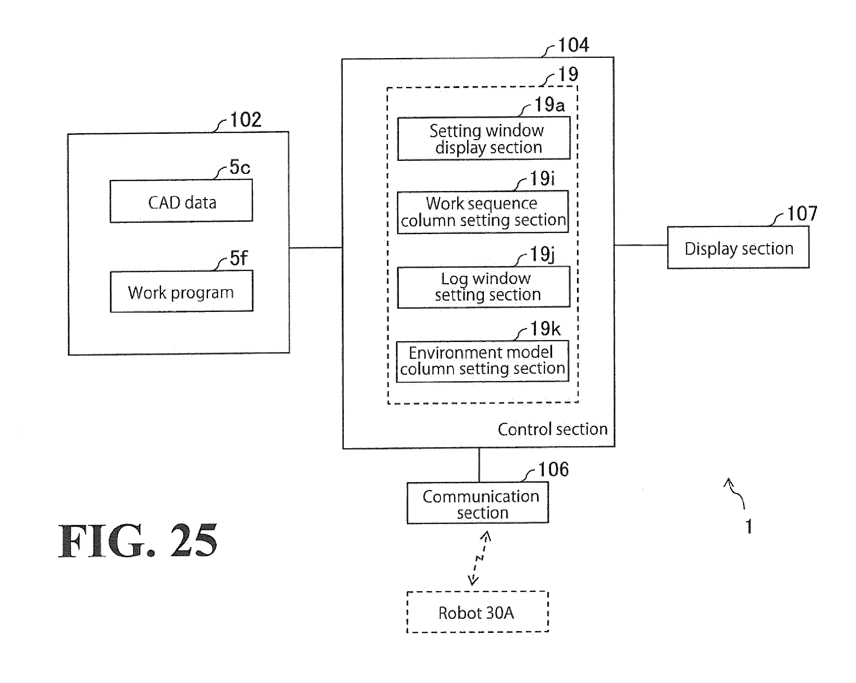

Similarly to the task planning, the display control section 19 controls the display section 107 to display setting windows that correspond to the processing of the above-described elements. Specific examples of the setting windows will be described later. As shown in FIG. 24, an exemplary setting window in the path planning includes a work sequence column, a movement path preparation log column, and an environment model column. As shown in FIG. 25, the display control section 19 includes elements to display the setting windows, namely, a work sequence column setting section 19i, a log column setting section 19j, and an environment model column setting section 19k.

From the setting window data area 5g, the setting window display section 19a acquires setting windows corresponding to the work selected by the operator, and displays the setting windows on the display section 107.

When the work acquisition section 12 acquires the work selected by the operator, the work sequence column setting section 19i refers to the work program area 5f to set (register), in the work sequence column, a work sequence corresponding to the work (steps including the sub-job programs associated with the work program) (see FIG. 22).

From the work sequence of the steps set in the work sequence column, the log column setting section 19j selects a log indicating progress of preparation of the movement path associated with the step selected by the operator, and displays the log in the movement path preparation log column. Displaying the log enables the operator to recognize the progress (development) of preparation of the movement path.

The environment model column setting section 19k displays an image of a three-dimensional model in the environment model column based on the position information of the parts, tool, work stand, and robot acquired by the position acquisition section 22, and based on the three-dimensional model data stored in the CAD data area 5c. Also the environment model column setting section 19k displays the positional relationship of the parts, tool, work stand, and robot based on a result of the determination by the movement determination section 23.

The method of preparing the movement paths in the robot control apparatus 1 (path planning) will be described by referring to a specific example. The following description will exemplify the method of preparing the movement paths with work A, which has been prepared in the task planning.

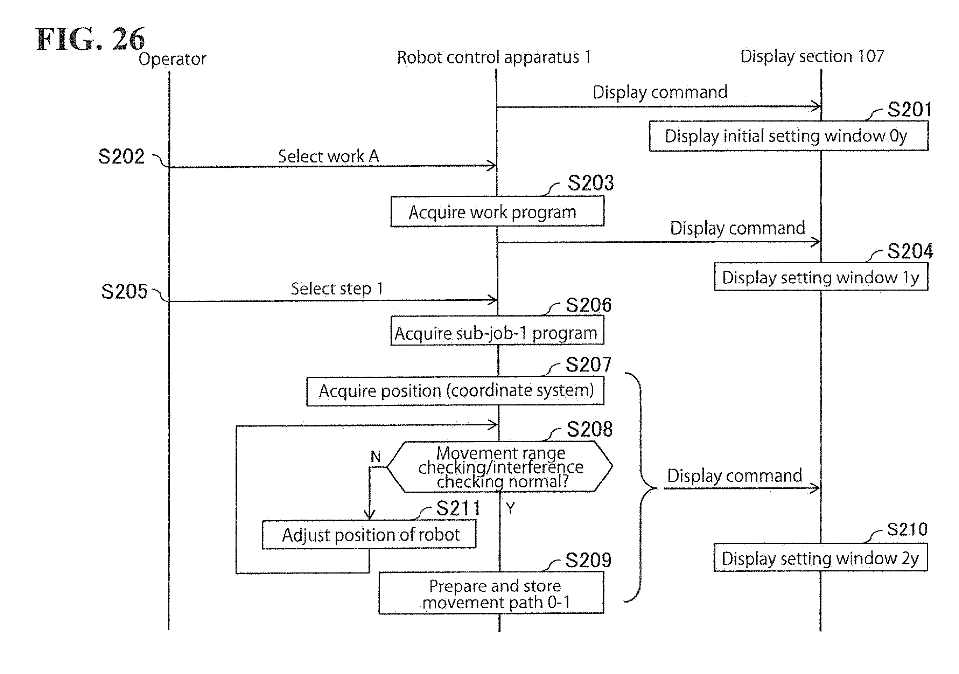

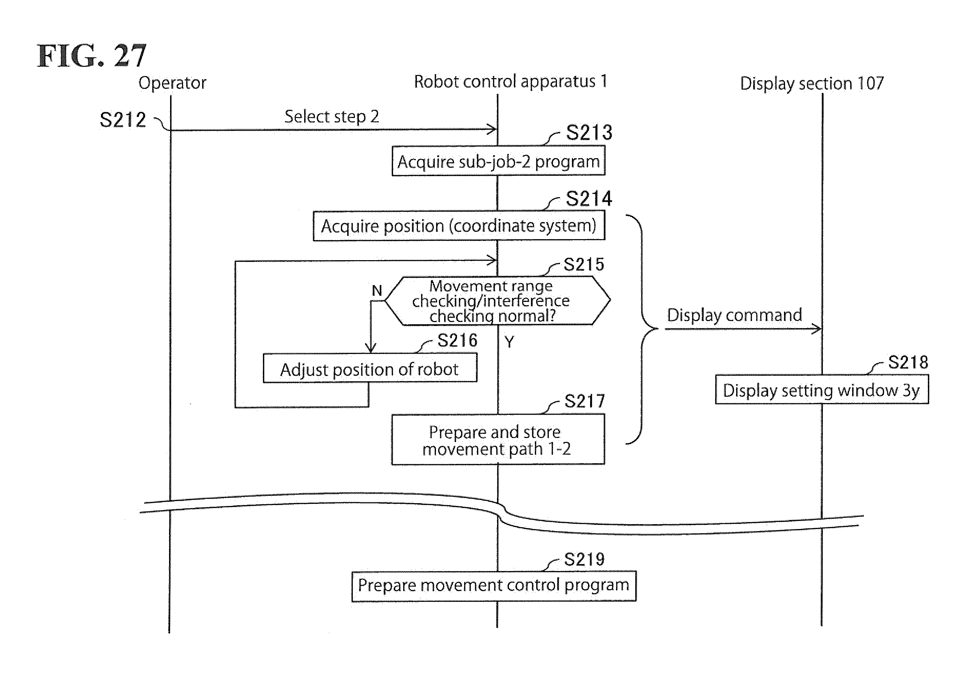

FIGs. 26 and 27 are flowcharts illustrating operations of the robot control apparatus 1. FIGs. 26 and 27 show a parallel arrangement of an operation flow of the operator, an operation flow of the robot control apparatus 1 based on the operation of the operator, and a display flow of the display section 107. The display processing of the display section 107 is implemented in accordance with a display command from the display control section 19 in the robot control apparatus 1.

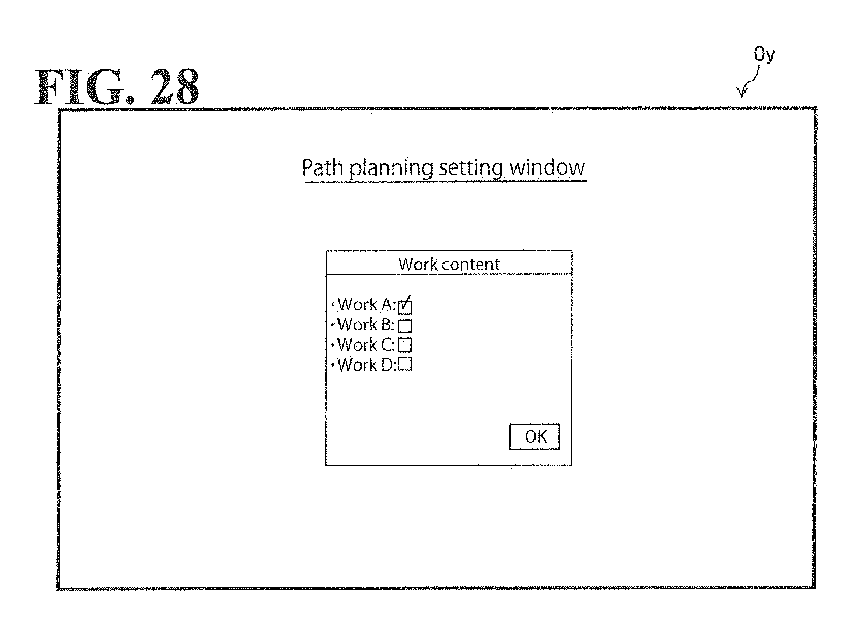

First, at the start of processing of the path planning, the display section 107 displays an initial setting window (S201). In the example shown in FIG. 28, the initial setting window displays a window (setting window 0y) for the operator to select work. On the initial setting window, the operator selects "Work A" as the work and presses "OK" button (S202). When the work acquisition section 12 acquires a result of the selection (work A) by the operator, the program acquisition section 21 acquires the work program of work A from the work program area 5f (S203).

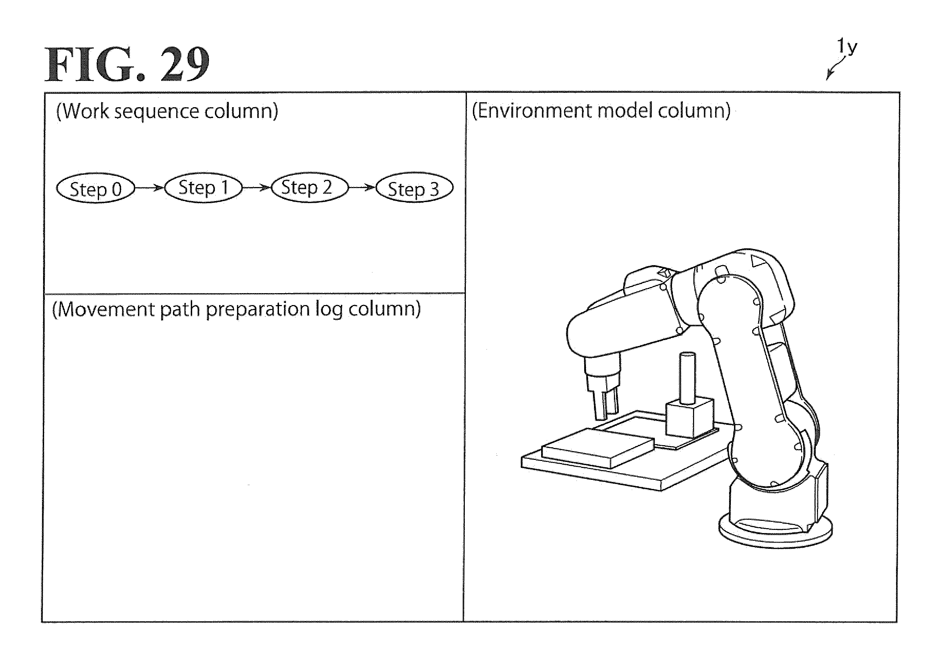

Next, the setting window display section 19a acquires a setting window corresponding to work A (see FIG. 24) from the setting window data area 5g. The work sequence column setting section 19i sets a work sequence of the work program of work A in the work sequence column of the setting window. Based on the three-dimensional model data stored in the CAD data area 5c, the environment model column setting section 19k sets a three-dimensional model in the environment model column. Thus, the display section 107 displays a setting window 1y, in which the columns are filled in by the setting sections (S204). FIG. 29 shows an exemplary setting window 1y.

Next, on the setting window 1y, the operator selects "Step 1" in the work sequence column (S205). For example, the operator uses a mouse to click on "Step 1" on the setting window. When the operator selects "Step 1", the program acquisition section 21 acquires the sub-job-1 program of step 1 from the work program area 5f (S206), and the position acquisition section 22 acquires the positions (coordinate systems) of the respective parts, tool, work stand, and robot 30A from the position data area 5i (S207).

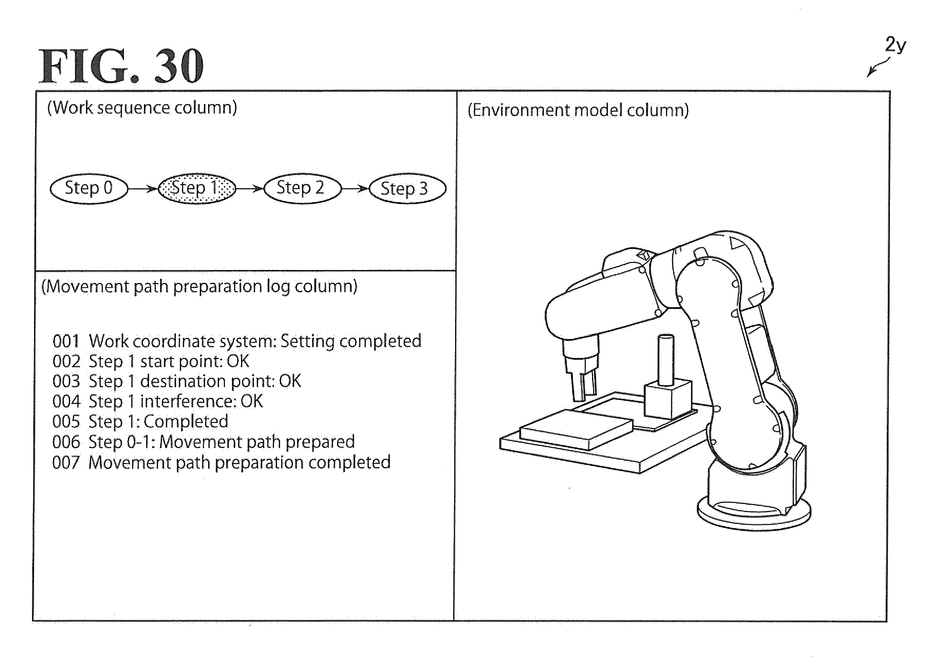

Next, the movement determination section 23 performs movement range checking and interference checking based on the sub-job-1 acquired by the program acquisition section 21 and based on the position information acquired by the position acquisition section 22 (S208). When both checking operations are found normal, the path preparation section 24 prepares the movement path 0-1 of the robot 30A between step 0 and step 1, and associates the prepared movement path 0-1 with the sub-job-1 program (see FIG. 22) so as to store the resulting movement path 0-1 in the work program area 5f (S209). The log column setting section 19j displays a log indicating progress of preparation of the movement path 0-1 in the log setting column (S210). FIG. 30 shows an exemplary setting window 2y in which the log is displayed.

When at least one of the movement range checking and the interference checking is found abnormal, the position adjustment section 25 adjusts the position of the robot 30A in the virtual space (S211), and the processing returns to S208.

Based on the movement path 0-1 prepared in the above-described manner, position information and coordinate information (*Coord, P1,* and *P2*) of the sub-job-1 program are determined.

When the operator selects "Step 2" in the work sequence column (S212), the program acquisition section 21 acquires the sub-job-2 program of step 2 from the work program area 5f (S213), and the position acquisition section 22 acquires the positions (coordinate systems) of the respective parts, tool, work stand, and robot 30A from the position data area 5i (S214).

Next, the movement determination section 23 performs movement range checking and interference checking based on the sub-job-2 program acquired by the program acquisition section 21 and based on the position information acquired by the position acquisition section 22 (S215). Description will be made in detail with regard to the case where the movement range checking is found abnormal. The position adjustment section 25 adjusts the position of the robot 30A in the virtual space (S216). For example, when the robot 30A in step 2 is marked at -α mm on the X coordinate, the base position of the robot 30A is adjusted to +α mm on the X coordinate. After the position adjustment, the processing returns to S215, where the movement determination section 23 performs the movement range checking and the interference checking again. The position adjustment with respect to step 2 may cause a displacement of the movement position in the previous step 1, which in turn may cause the robot 30A to move out of the movable range or interfere with obstacles. In view of this, when the movement range checking and the interference checking are performed again, the previous step 1 is also checked.

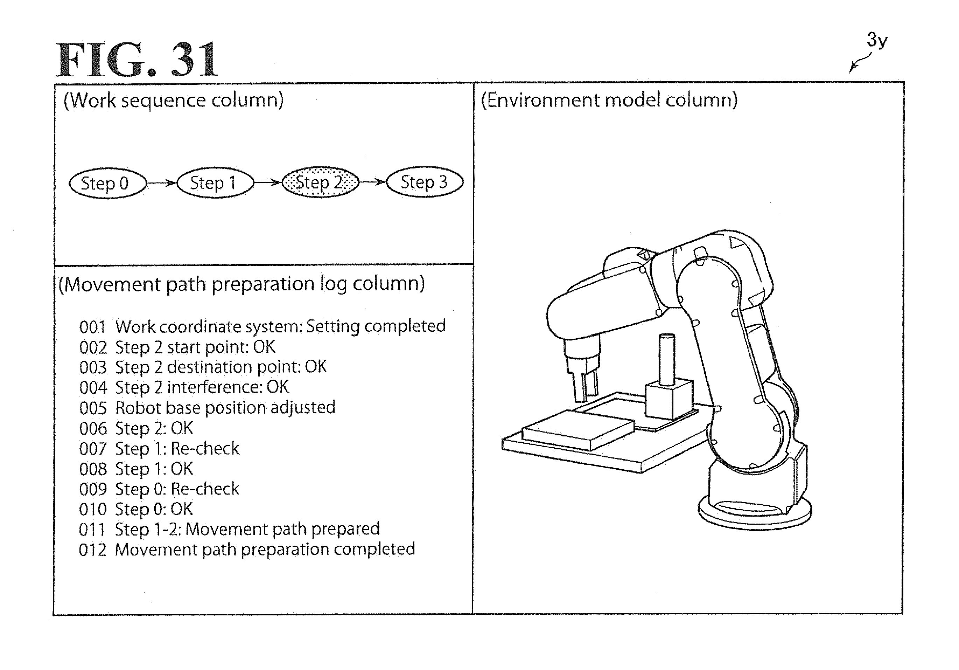

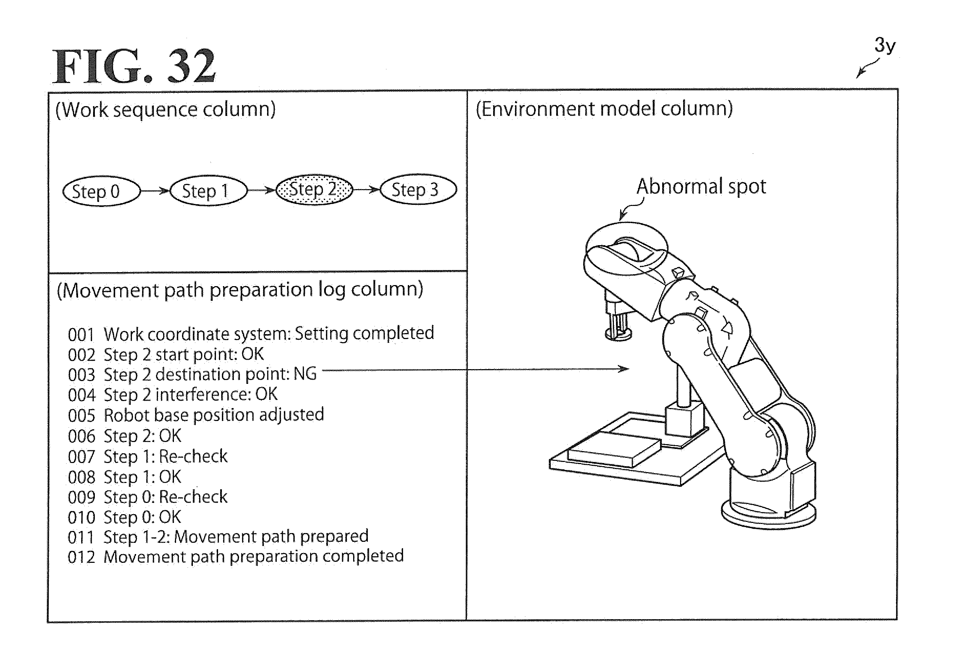

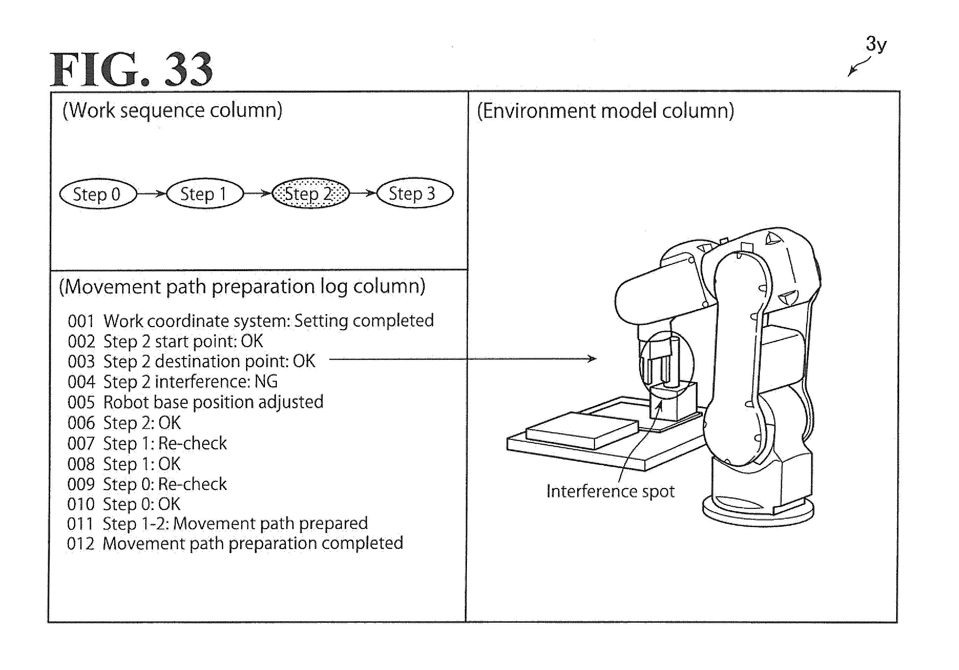

After the position adjustment ends, the path preparation section 24 prepares the movement path 1-2 of the robot 30A between step 1 and step 2, and associates the prepared movement path 1-2 with the sub-job-2 program (see FIG. 22) so as to store the resulting movement path 1-2 in the work program area 5f (S217). The log column setting section 19j displays a log indicating progress of preparation of the movement path 1-2 in the log setting window (S218). FIG. 31 shows an exemplary setting window 3y in which the log is displayed. Here, the environment model column setting section 19k may indicate in the environment model column an abnormal spot detected in the movement range checking and the interference checking. FIG. 32 illustrates a case where the movement range of the robot 30A is displaced from the movable range. For ease of identification, the abnormal spot may be marked or colored. FIG. 33 illustrates a case where the robot 30A interferes with another object.

Based on the movement path 1-2 prepared in the above-described manner, position information and coordinate information (*Coord, P1,* and *P2*) of the sub-job-2 program are determined. Similarly, the movement path 2-3 prepared in association with step 3 is associated with the sub-job-3 program (see FIG. 22) and stored in the work program area 5f. Then, based on the movement path 2-3, position information and coordinate information (*Coord, P1,* and *P2*) of the sub-job-3 program are determined.

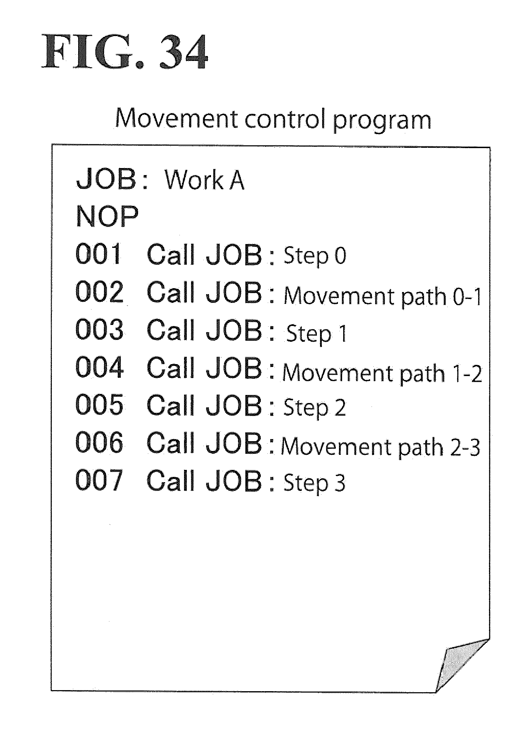

When the movement path 2-3 in association with step 3 is prepared, the movement control program preparation section 26 prepares a movement control program corresponding to work A based on the sub-job-1 program, the sub-job-2 program, and the sub-job-3 program, which are respectively associated with the movement path 0-1, the movement path 1-2, and the movement path 2-3 (S219). FIG. 34 shows an exemplary movement control program. The movement control program preparation section 26 stores the prepared movement control program corresponding to work A in the movement control program area 5j.

The robot 30A makes movements corresponding to work A based on the movement control program prepared in the robot control apparatus 1.

The path planning of the robot control apparatus 1 according to this embodiment facilitates preparation of the movement paths, and also enables the operator to recognize (visually confirm) the progress (development) of preparation of the movement paths.

The control section 104 may further include the likelihood calculation section 27 (see FIG. 23). The likelihood calculation section 27 calculates an error likelihood σ based on the position information acquired by the position acquisition section 22. The error likelihood σ corresponds to a tolerance value of error in the positional relationship between the robot 30 and the work stand with the robot 30 installed, and the error likelihood σ serves as a decision index in a work coordinate system of calibration. In the calibration, the actual positions of the work stands relative to the positions of the installed robots 30A, 30B, and 30C are measured. Specifically, in the calibration, after the robot 30A is installed, the distal end of an arm of the robot 30A is moved to a relative position indicated by the position measurement data (designed position of the work stand relative to the robot 30A). Then, the distal end of the arm is further moved to coincide with a feature spot of the work stand based on a camera or an output from a contact sensor disposed on the distal end of the arm. Based on the states of joints of the arm, a relative position of the feature spot of the work stand is calculated. The calculated relative position is regarded as the actual relative position of the work stand (which may not necessarily be the same as the designed position). In an example case of the calibration where the error in the positional relationship between the robot 30 and the work stand is in excess of the error likelihood σ, it is possible to perform the path planning again. Thus, use of the error likelihood σ in the calibration enhances work efficiency in preparing the work coordinate system.

### [Specific example of the robot system]

A specific example of the robot system including the robot control apparatus 1 according to this embodiment will be described below.

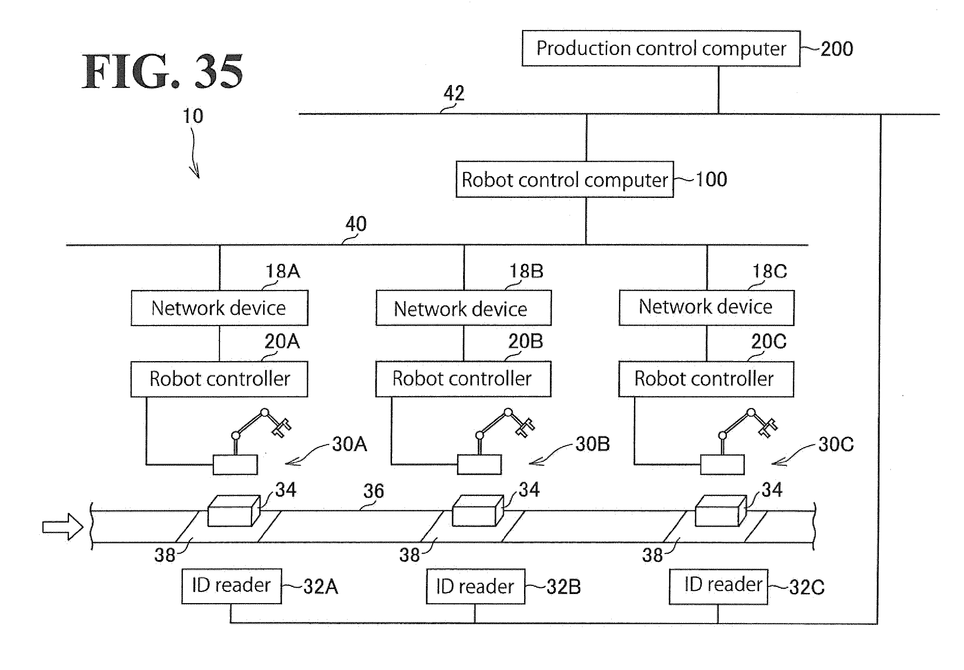

FIG. 35 illustrates a general arrangement of a robot system 10. The robot system 10 shown in FIG. 35 is installed in production sites of transportation machines such as automobiles and in production sites of electric appliances such as television receivers. In such production site, a transfer device 36 such as a belt conveyer and a roller conveyer is installed. As work space of the robots, work stands 38 are disposed. On the work stands 38, work targets 34 such as unfinished automobiles and television receivers are disposed. The transfer device 36 transfers the work targets 34 on the work stands 38 in one direction. On the side of the transfer device 36, the industrial articulated robots 30A, 30B, and 30C are disposed in this order at intervals from the upstream side to the downstream side. The robots 30A, 30B, and 30C perform predetermined kinds of work, such as mounting of parts, with respect to the work targets 34.

Robot controllers 20A, 20B, and 20C are computers respectively coupled to the robots 30A, 30B, and 30C in order to control the respective robots. Network devices 18A, 18B, and 18C are respectively coupled to the robot controllers 20A, 20B, and 20C. All the network devices 18A, 18B, and 18C are coupled to a robot network 40. Also to the robot network 40, a robot control computer 100 is coupled to support and control the operation of the robot controllers 20A, 20B, and 20C. The robot controllers 20A, 20B, and 20C are individually communicable with the robot control computer 100 respectively through the network devices 18A, 18B, and 18C and through the robot network 40. The network devices 18A, 18B, and 18C, and the robot control computer 100 store network identifiers such as addresses used in the robot network 40. The network identifiers are used to identify transmission sources and destinations. The robot control apparatus 1 according to this embodiment is applicable as the robot control computer 100.

The transfer device 36 stops the work stands 38 beside the positions of the installed robots 30A, 30B, and 30C. When the robots 30A, 30B, and 30C end their work, the transfer device 36 moves the work stands 38 to beside the positions of the downstream robots. The robot controllers 20A, 20B, and 20C may notify the transfer device 36 that the respective robots 30A, 30B, and 30C have ended their work.

Across the transfer device 36, work target ID readers 32A, 32B, and 32C are disposed respectively in opposition to the positions of the robots 30A, 30B, and 30C. The work targets 34 have their own ID (identification information) in a mechanically readable form such as a one-dimensional or two-dimensional bar code. The ID of each work target 34 is attached to the work target 34 or the work stand 38, on which the work target 34 is disposed. Examples of the ID of each work target 34 include, but are not limited to, a final or temporary serial number and a final or temporary lot number assigned to the work target 34. The work target ID readers 32A, 32B, and 32C, such as bar code readers, read the ID attached to the work targets 34 or the work stands 38, and notify a production control computer 200 of the ID through a production control network 42. That is, the work target ID readers 32A, 32B, and 32C and the production control computer 200 are coupled to the production control network 42. Also the robot control computer 100 (robot control apparatus 1), described above, is coupled to the production control network 42. This enables the robot control computer 100 and the production control computer 200 to communicate with each other.

When, for example, the robot 30A is introduced in the robot system 10 or when the robot 30A is re-arranged in the robot system 10, the robot 30A is installed at an expected position, and the robot controller 20A is coupled to the network device 18A. This prompts the robot control computer 100 (robot control apparatus 1) to transmit to the robot controller 20A the movement control program (see FIG. 34) to be executed by the robot controller 20A. The robot controller 20A executes the movement control program transmitted from the robot control apparatus 1. The movement control program describes movements to be made by the actuators at the various portions of the arm of the robot 30A in accordance with a camera or an output from a contact sensor disposed on the distal end of the arm of the robot 30A or in accordance with an output from a timer. When this movement control program is executed, control commands are successively transmitted from the robot controller 20A to the robot 30A so as to control the movement (for example, the movement in work A) of the robot 30. This ensures that the robot controller 20A reliably controls the robot 30A to perform an expected kind of work. The same to the robots 30B and 30C. The industrial articulated robots 30A, 30B, and 30C are capable of performing various kinds of work by changing the movement control programs. This enables the robots 30A, 30B, and 30C to, one day, perform a kind of work at a location of a production site and to, another day, perform a different kind of work at a different location of the production site. The use of the robots 30A, 30B, and 30C for this purpose is facilitated in this embodiment, since this embodiment provides the robot controllers 20A, 20B, and 20C with movement control programs suitable for the positions of the robots 30A, 30B, and 30C.

Each of the robot controllers 20A, 20B, and 20C maybe the robot control apparatus 1 according to this embodiment.
- 1: Robot control apparatus
- 10: Robot system
- 30A, 30B, 30C: Robot
- 102: Storage section
- 104: Control section
- 106: Communication section
- 107: Display section
- 5a: Work data area (Work table)
- 5b: Template data area
- 5c: CAD data area (CAD data table)
- 5d: Skill data area (Work parameter table)
- 5e: Robot data area (Robot data table)
- 5f: Work program area
- 5g: Setting window data area
- 5h: Part data area
- 5i: Position data area
- 5j: Movement control program area
- 11: Operation reception section
- 12: Work acquisition section
- 13: Work step acquisition section
- 14: Part information acquisition section
- 15: Tool information acquisition section
- 16: Parameter acquisition section
- 17: Robot information acquisition section
- 18: Work program preparation section
- 19: Display control section
- 21: Program acquisition section
- 22: Position acquisition section
- 23: Movement determination section
- 24: Path preparation section
- 25: Position adjustment section
- 26: Movement control program preparation section
- 27: Likelihood calculation section
- 19a: Setting window display section
- 19b: Part column setting section
- 19c: Tool column setting section
- 19d: Environment model column setting section
- 19e: Parameter setting section
- 19f: Half-finished product window setting section
- 19g: Work process column setting section
- 19h: Work sequence column setting section
- 19i: Work sequence column setting section
- 19j: Log column setting section
- 19k: Environment model column setting section

## Claims

1. A robot control apparatus 1, **characterized by**:
a storage section 102 configured to associate information of work performed by a robot with a template to prepare a work program indicating content of the work, and configured to store the information in association with the template;
a display control section 19 configured to control a display section 107 to display, in order, setting windows respectively corresponding to work steps of the work; and
a work program preparation section 18 configured to, in response to an operator selecting the work, prepare the work program indicating the content of the work selected by the operator based on the template corresponding to the work selected by the operator and based on setting information that the operator inputs on at least one setting window among the setting windows.

2. The robot control apparatus 1 according to claim 1, wherein the display control section 19 is configured to contain, in at least one setting window among the setting windows, a selection window for the operator to select a tool and a part available for the work.

3. The robot control apparatus 1 according to claim 1 or 2, wherein the work program preparation section 18 is configured to prepare work step programs respectively indicating contents of the work steps, and configured to prepare the work program based on the prepared work step programs.

4. The robot control apparatus 1 according to any one of claims 1 to 3, wherein the information of the is associated with robot identification information for identifying the robot to perform the work.

5. The robot control apparatus 1 according to any one of claims 1 to 4,
wherein the display control section 19 is configured to control the display section 107 to display a setting window for the operator to input a work condition under which the robot performs the work, and
wherein the work program preparation section 18 is configured to prepare the work program based on the work condition input by the operator.

6. The robot control apparatus 1 according to claim 5, further comprising a determination section 16 configured to determine whether the work condition input by the operator satisfies a predetermined threshold,
wherein when the input work condition does not satisfy the predetermined threshold, the display control section 19 is configured to control the display section 107 to display a message to prompt re-entry of work condition.

7. The robot control apparatus 1 according to any one of claims 1 to 6, wherein the display control section 19 is configured to control the display section 107 to display model images of a tool and a part available for the work.

8. The robot control apparatus 1 according to any one of claims 1 to 7, wherein the display control section 19 is configured to contain, in each of the setting windows corresponding to the respective work steps, a model image indicating a state of production in previous work steps among the work steps.

9. A method for controlling a robot, **characterized by**:
in response to an operator selecting work performed by a robot, acquiring from a storage section 102 a template corresponding to the work to prepare a work program indicating content of the work, the storage section 102 storing the template in association with information of the work;
displaying, in order, setting windows respectively corresponding to work steps of the work; and
preparing the work program indicating the content of the work based on the acquired template and based on setting information that the operator inputs on at least one setting window among the setting windows.
